# DEMANDE DE BREVET EUROPEEN

(11) **EP 1 089 289 A1**
(43) Date de publication de la demande: **04.04.2001**
(21) Numéro de dépôt: 00402444.4
(22) Date de dépôt: 05.09.2000
(51) Int. Cl.: G11C 16/02, G11C 7/10, G11C 16/08, G11C 16/10

(54) **Mémoire en circuit intégré à accès série**

(30) Priorité: 29.09.1999 FR 9912150
(71) Demandeur: STMicroelectronics S.A., 94250 Gentilly (FR)
(72) Inventeur: Zink, Sébastien, 75116 Paris (FR); Bertrand, Bertrand, 75116 Paris (FR); Naura, David, 75116 Paris (FR)
(74) Mandataire: Ballot, Paul

(57) **Abrégé**

L'invention propose une mémoire en circuit intégré, du type à accès série, notamment en technologie EEPROM, comportant une entrée de données (DI) et une sortie de données (DO), un plan mémoire proprement dit (MM) organisé en mots mémoire, ainsi qu'un ensemble (LAT) de registres de colonnes, un tel registre étant associé à au moins un mot mémoire de la mémoire, des premiers moyens pour, lors d'une opération d'écriture d'un mot binaire dans un mot mémoire déterminé (M0-M7), charger les données binaires dudit mot binaire reçues en série sur l'entrée de données (DI) directement dans des bascules de mémorisation et de commutation (HV0-HV7) respectives du registre de colonnes (R1) associé audit mot mémoire (M0-M7) et/ou des seconds moyens pour, lors d'une opération de lecture d'un mot binaire dans un mot mémoire, lire successivement les données binaires mémorisées dans les cellules mémoire du mot mémoire et délivrer directement, sous forme série, chaque donnée binaire lue sur la sortie de donnée (DO) de la mémoire.

## Description

La présente invention concerne une mémoire en circuit intégré, du type à accès série.

Elle se rapporte au domaine des mémoires en circuit intégré, notamment en technologie EEPROM (de l'anglais "Electrically Erasable and Programmable Read Only Memory" qui signifie mémoire à lecture seule programmable et effaçable électriquement "). Néanmoins, elle peut aussi s'appliquer à une mémoire dans une autre technologie, par exemple une mémoire en technologie Flash-EPROM, ou autre.

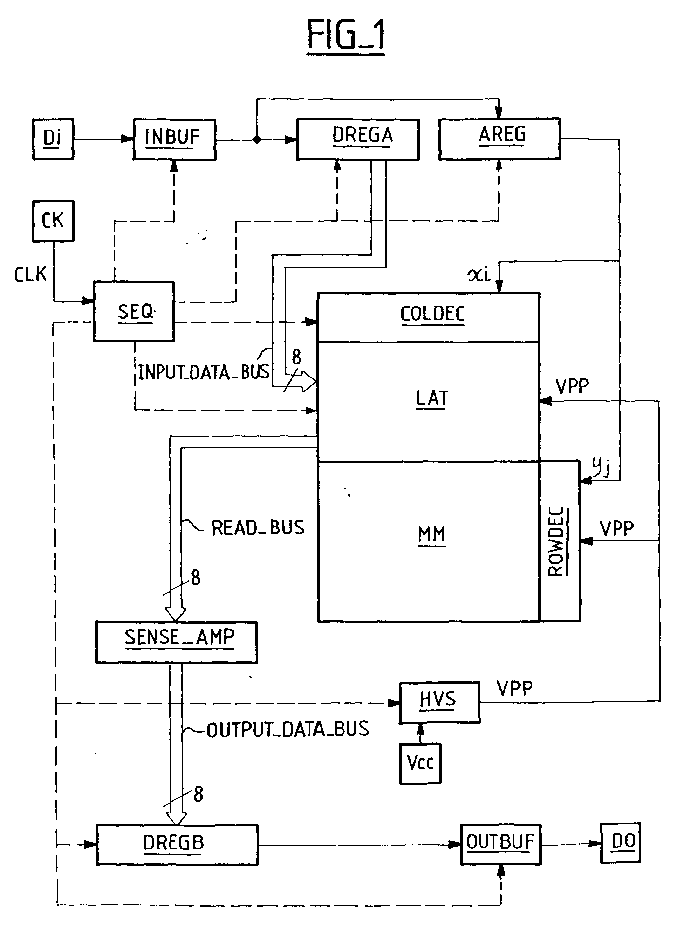

L'architecture d'une mémoire à accès série, telle qu'elle est connue dans l'état de la technique, est représentée schématiquement à la figure 1.

La mémoire comprend tout d'abord un plan mémoire MM proprement dit. Le plan mémoire est constitué d'une matrice de cellules mémoire réalisées selon la technologie considérée. Une cellule mémoire mémorise la valeur d'un bit de la mémoire. Les cellules d'une même colonne sont connectées à une même ligne de connexion, classiquement représentée verticalement et appelée ligne de bits. En outre, les cellules d'une même ligne sont connectées à une même ligne de connexion, classiquement représentée horizontalement et appelée ligne de mots.

En technologie EEPROM, le plan mémoire est organisé en mots mémoire. Un mot mémoire désigne un certain nombre de cellules adjacentes d'une même ligne de la mémoire (par exemple huit telles cellules). Ce mot mémoire mémorise huit données binaires qui forment un mot binaire. Un mot mémoire mémorise donc la valeur d'un octet de la mémoire. En général, on écrit et on lit dans la mémoire au moins huit données binaires simultanément, qui forment un mot binaire. Dans certains cas, on écrit simultanément dans plusieurs mots mémoire d'une même ligne de la mémoire, voire dans tous les mots mémoire de cette ligne : on parle alors d'écriture en mode page. Dans la suite, le terme "mot" sera parfois utilisé de manière isolée pour désigner tantôt un mot binaire tantôt un mot mémoire, selon le contexte.

La mémoire comprend aussi un circuit décodeur de lignes ROWDEC et un circuit décodeur de colonnes COLDEC, ainsi qu'un ensemble LAT de registres de colonnes ("Column Register", en anglais). Chaque registre de colonnes est associé à au moins un mot mémoire de la mémoire. Lorsque la mémoire comprend plusieurs lignes de cellules, un registre de colonnes est en général associé aux mots mémoires de chaque ligne qui sont adjacents verticalement. Il comprend huit bascules de mémorisation et de commutation ("Latch", en anglais), dans lesquelles respectivement huit données sont chargées en vue de l'écriture dans le mot mémoire associé.

Pour l'écriture ou la lecture d'un mot binaire dans la mémoire, une instruction est reçue sur une entrée de données DI de la mémoire, selon un protocole de transmission série déterminé (par exemple le protocole I²C, le protocole SPI ou le protocole MICROWIRE). Les données binaires de l'instruction étant transmises sur cette entrée sous forme d'un signal électrique, elles sont tout d'abord, en général, remises en forme grâce à un circuit tampon d'entrée INBUF ("Input Buffer", en anglais). Un tel circuit n'est cependant pas obligatoire, et peut être omis dans certaines applications. En général, les informations suivantes sont contenues dans l'instruction : un code d'opération (exemple : écriture ou lecture), une adresse de la mémoire désignant un mot mémoire, et le cas échéant au moins un mot de données à écrire (pour une opération d'écriture). Un séquenceur SEQ génère des signaux de commande adaptés à la bonne gestion de la mémoire lors de l'exécution de l'instruction reçue. Le séquenceur SEQ reçoit un signal d'horloge CLK sur une entrée d'horloge CK de la mémoire. Les signaux de commande qu'il génère sont matérialisés par des flèches en traits discontinus.

Ainsi, les données correspondant à l'adresse du mot mémoire concerné par l'opération sont chargées dans un registre d'adresse AREG, sous la commande du séquenceur SEQ. De là, une partie xᵢ de l'adresse du mot mémoire, appelée adresse de colonne, est fournie en entrée du circuit décodeur de colonnes COLDEC. Ce dernier a pour fonction de sélectionner le registre de colonne associé au mot mémoire concerné. Une autre partie yⱼ de l'adresse du mot mémoire, appelée adresse de ligne, est fournie en entrée du circuit décodeur de lignes ROWDEC. Ce dernier a pour fonction de sélectionner la ligne de mots du mot mémoire concerné.

De même, les données de l'instruction correspondant au mot de données à écrire (le cas échéant) sont chargées dans un premier registre à décalage d'entrée DREGA, sous la commande du séquenceur SEQ. Le registre DREGA est un registre huit bits, c'est à dire qu'ils comprend huit bascules de mémorisation en série, pour la mémorisation respectivement de huit données reçues consécutivement. Chaque bascule comporte une sortie non inverseuse qui délivre la donnée binaire reçue en entrée, et une sortie inverseuse qui délivre la donnée binaire inverse de celle reçue en entrée. Ces bascules sont reliées en série par l'intermédiaire de leurs sorties non inverseuses. Le registre à décalage DREGA assure une fonction de conversion série/parallèle du flot de données binaires reçues par la mémoire via l'entrée DI. En effet, les sorties inverseuses des huit bascules du registres DREGA sont reliées à un bus d'entrée de données INPUT_DATA_BUS constitué d'un faisceau de huit lignes respectives. Le bus INPUT_DATA_BUS est par ailleurs relié à l'ensemble LAT de registres de colonnes pour y délivrer, sous forme parallèle, huit données binaires qui sont les données binaires inverses des données binaires reçues sur l'entrée de données DI. Ces données binaires sont chargées dans les bascules de mémorisation et de commutation du registre de colonne associé au mot mémoire concerné, sous la commande du séquenceur SEQ.

L'écriture d'un mot binaire dans un mot mémoire d'une mémoire en technologie EEPROM comprend une étape d'effacement simultané de toutes les cellules du mot mémoire (en sorte qu'elles mémorisent la donnée binaire 1), puis une étape de programmation conditionnelle mise en oeuvre simultanément pour toutes les cellules du mot mémoire (en sorte que seules les cellules ainsi conditionnellement programmées mémorisent la donnée binaire 0). L'effacement et la programmation d'une cellule mémoire en technologie EEPROM s'effectuent par effet tunnel ("Fowler Nordheim"). A cet effet, une haute tension de programmation ou d'effacement VPP, de l'ordre de 18 volts, est générée par un circuit générateur HVS à partir de la tension d'alimentation VCC de la mémoire, qui est de l'ordre de 5 volts. Le circuit générateur HVS est relié à une borne d'entrée Vcc de la mémoire. Il s'agit par exemple d'une pompe de charge ou un circuit dit "de Schenkel". La haute tension VPP est fournie en entrée de l'ensemble LAT d'une part et du circuit ROWDEC d'autre part.

Une opération de lecture d'un mot binaire dans un mot mémoire déterminé du plan mémoire MM met en oeuvre un circuit de lecture SENSE_AMP. Ce circuit comprend huit amplificateurs de lecture reliés, par l'intermédiaire d'un bus de lecture READ_BUS constitué d'un faisceau de huit lignes, respectivement aux huit bascules de mémorisation et de commutation du registre de colonnes associé au mot mémoire concerné. Le circuit de lecture SENSE_AMP délivre des données binaires 1 ou 0 en fonction de la détection ou non d'un courant sur les lignes de bits concernées de la mémoire.

Les données binaires en sortie du circuit de lecture SENSE_AMP sont transmises, en parallèle, à un second registre à décalage de sortie DREGB, par l'intermédiaire d'un bus de sortie de données OUTPUT_DATA_BUS. Le registre à décalage DREGB assure une fonction de conversion parallèle/série des données binaires lues dans la mémoire, en vue de délivrer ces données sous forme série sur une borne de sortie de données DO. A cet effet, la sortie du registre à décalage DREGB est reliée à la borne de sortie DO par l'intermédiaire d'un circuit tampon de sortie OUTBUF ("Output Buffer", en anglais). La fonction du circuit OUTBUF est essentiellement d'amplifier un signal électrique portant les données lues et délivré par la borne_DO. Un tel circuit n'est cependant pas obligatoire, et peut être omis dans certaines applications.

Selon un inconvénient des mémoires à accès série d'architecture connue, le premier et le second registres à décalage respectivement DREGA et DREGB occupent beaucoup de place sur le substrat de silicium dopé sur lequel la mémoire est réalisée. Ceci est dû au nombre important de transistors qui les composent. On conçoit que cette surface occupée par les registres à décalage soit pénalisante en termes de coût de fabrication, surtout pour les mémoires de faible capacité (avec peu d'octets mémorisés).

L'invention vise à -pallier cet inconvénient des mémoires de l'état de la technique.

A cet effet, l'invention propose une mémoire en circuit intégré, du type à accès série, notamment en technologie EEPROM, comportant une entrée de données et une sortie de données, un plan mémoire proprement dit organisé en mots mémoire, ainsi qu'un ensemble de registres de colonnes, un tel registre étant associé à au moins un mot mémoire de la mémoire, des premiers moyens pour, lors d'une opération d'écriture d'un mot binaire dans un mot mémoire déterminé, charger les données binaires dudit mot binaire reçues en série sur l'entrée de données directement dans des bascules de mémorisation et de commutation respectives du registre de colonnes associé audit mot mémoire et/ou des seconds moyens pour, lors d'une opération de lecture d'un mot binaire dans un mot mémoire, lire successivement les données binaires mémorisées dans les cellules mémoire du mot mémoire et délivrer directement, sous forme série, chaque donnée binaire lue sur la sortie de donnée de la mémoire.

Par le terme directement, il faut comprendre que la mémoire selon l'invention ne comporte pas de registre à décalage d'entrée et/ou de registre à décalage de sortie. Néanmoins, elle peut toujours comporter un circuit tampon d'entrée et/ou un circuit tampon de sortie, selon les besoins liés à l'application. Dit autrement, ce terme signifie que les données ne subissent pas de transformation série/parallèle en entrée ni de transformation parallèle/série en sortie. De par l'absence de registre à décalage d'entrée et/ou de registre à décalage de sortie, on obtient une mémoire qui occupe une surface de silicium réduite.

D'autres caractéristiques et avantages de l'invention apparaîtront à la lecture de la description qui va suivre. Celle-ci est purement illustrative et doit être lue en regard des dessins annexés, sur lesquels on a représenté :
- à la figure 1, déjà analysée : le schéma d'une mémoire à accès série selon l'état de la technique ;
- à la figure 2 : le schéma d'une bascule de mémorisation et de commutation d'un registre de colonnes connu dans l'état de la technique ;
- à la figure 3 : le schéma d'un registre de colonnes selon l'état de la technique ;
- à la figure 4 : le schéma d'une mémoire à accès série selon l'invention ;
- à la figure 5 : le schéma d'un registre de colonnes selon l'invention ;
- à la figure 6 : le schéma de certains moyens de la mémoire selon l'invention.

Pour la mise en oeuvre de l'étape de programmation conditionnelle d'une opération d'écriture dans la mémoire, la mémoire comprend, en général pour chaque ligne de bits, une bascule de mémorisation et de commutation ("Latch", en anglais). Un registre de colonnes comprend huit telles bascules pour permettre l'écriture simultanément dans toutes les cellules d'un même mot mémoire voire dans les cellules de tous les mots mémoire d'une même ligne de la mémoire (en mode page). Une telle bascule présente une double fonction. D'une part elle permet la mémorisation temporaire d'une donnée binaire en vue de l'écriture dans une cellule. D'autre part elle permet de porter à la tension VPP la ligne de bits à laquelle est reliée ladite cellule, si la donnée binaire à écrire est 0, ce qui provoque la programmation de la cellule. On parle de commutation conditionnelle pour désigner cette seconde fonction de la bascule.

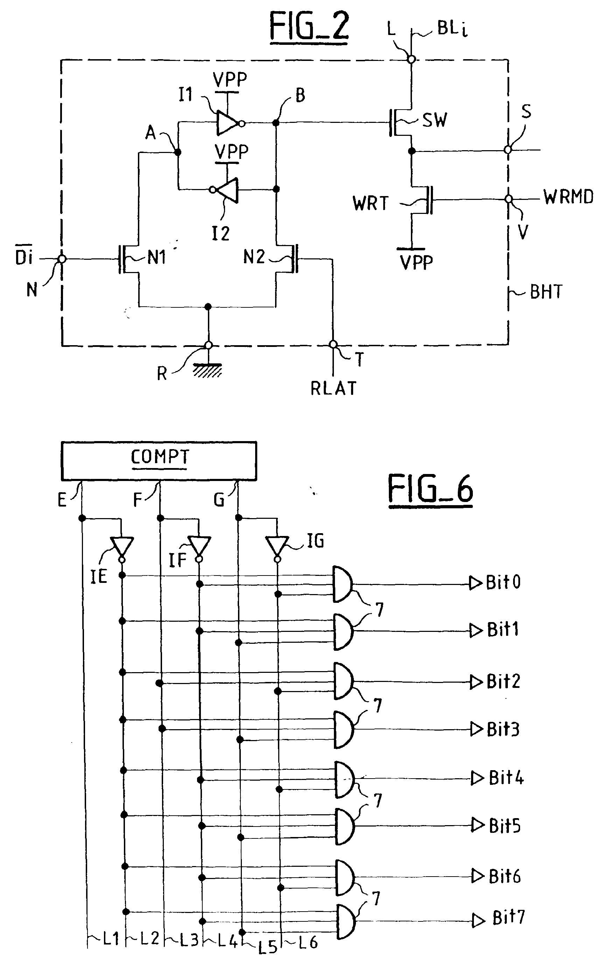

A la figure 2, on a représenté le schéma d'une bascule de mémorisation et de commutation telle qu'elle est connue dans l'état de la technique.

La bascule BHT représentée à la figure 2 comprend tout d'abord des moyens de mémorisation haute tension, pour le stockage temporaire d'une donnée binaire 1 ou 0, sous la forme respectivement d'une haute tension VPP ou d'une tension nulle.

Ces moyens comprennent classiquement deux inverseurs I1 et I2 connectés "tête-bêche" entre un noeud A et un noeud B de manière à produire l'effet de mémorisation. Ce sont des inverseurs haute tension, c'est à dire qu'ils peuvent recevoir et délivrer une tension soit nulle soit égale à VPP. Il s'agit classiquement d'inverseurs en technologie CMOS, c'est à dire comprenant un transistor MOS de type P et un transistor MOS de type N en série entre VPP et la masse, les grilles de commande des deux transistors étant reliées ensemble, et la sortie de l'inverseur étant prise sur le noeud correspondant à la source commune des deux transistors. Par convention, la sortie des moyens de mémorisation est prise sur le noeud B. Dit autrement, la donnée binaire mémorisée par la bascule est 0 lorsque le noeud B est porté à la tension nulle (potentiel de la masse) et est 1 lorsque le noeud B est porté à la tension VPP (potentiel référencé par rapport à la masse).

La bascule BHT comprend aussi des moyens de chargement, pour le chargement d'une donnée binaire dans les moyens de mémorisation haute tension.

Ces moyens de chargement comprennent d'une part un transistor MOS de type N, référencé N1, connecté au noeud A par son drain et à une entrée R de la bascule par sa source. En fonctionnement, l'entrée R est reliée à la masse via un transistor de sélection (non représenté). Le transistor N1 reçoit sur sa grille de commande un signal de donnée Di barre qui est un signal basse tension (i.e., dont le niveau est soit nul soit égal à VCC) représentant l'inverse de la donnée binaire à écrire. Dit autrement, le niveau du signal Di barre est nul si la donnée binaire à écrire est 1 et il est égal à VCC si la donnée binaire à écrire est 0. Le signal Di barre permet, lorsque son niveau est égal à VCC, de porter le noeud B à la tension VPP, ce qui charge la valeur binaire 1 dans les moyens de mémorisation haute tension I1,I2.

Les moyens ce chargement comprennent d'autre part un autre transistor MOS de type N, référencé N2, connecté au noeud B par son drain et à l'entrée R par sa source. On rappelle que, en fonctionnement, l'entrée R est reliée à la masse via un un transistor de sélection (non représenté). La grille de commande du transistor N2 est reliée à une entrée T de la bascule pour recevoir un signal RLAT de remise à zéro, qui est aussi un signal basse tension. Ce signal permet, lorsque son niveau est égal à VCC de porter le noeud B au potentiel de masse, ce qui charge la valeur binaire 0 dans les moyens de mémorisation I1,I2.

Le chargement d'une donnée binaire dans les moyens de mémorisation I1,I2 est effectué en deux temps : dans un premier temps, le signal RLAT passe à VCC ce qui relie le noeud B à la masse à travers le transistor N2 qui est conducteur, en sorte qu'un 0 est chargé dans les moyens de mémorisation I1,I2 ; le signal RLAT repasse alors à 0 volt pour bloquer le; transistor N2 ; dans un deuxième temps, l'inverse de la donnée binaire à écrire est porté sur la grille de commande du transistor N1 au moyen du signal Di barre, en sorte que le noeud A est porté au potentiel de masse à travers le transistor N1 uniquement lorsque la donnée binaire à écrire est 0, ce qui a pour effet de charger la valeur binaire 1 dans les moyens de mémorisation I1,I2.

La bascule BHT comprend en outre des moyens de commutation conditionnelle, pour porter ou non à la tension VPP, en fonction de la valeur mémorisée par les moyens de mémorisation haute tension, la ligne de bits BLi reliée une sortie L de la cellule.

Ces moyens de commutation conditionnelle comprennent un transistor MOS de type N, référencé SW, connecté à la sortie des moyens de mémorisation haute tension I1,I2 (i.e., au noeud B) par sa grille de commande, à une entrée L de la bascule par sa source, la ligne de bit BLi étant reliée à cette entrée L, et, par son drain, à la source de haute tension d'alimentation VPP à travers un transistor MOS de type N référencé WRT. Le transistor WRT reçoit sur sa grille de commande un signal WRMD appliqué sur une entrée V de la bascule, qui le rend conducteur lors des opérations d'écriture dans la mémoire (i.e., en mode écriture) et qui le bloque lors des opérations de lecture dans la mémoire (i.e., en mode lecture). Le transistor WRT a donc pour fonction d'isoler la ligne de bits BLi de la haute tension VPP en mode lecture. Le transistor SW assure, en mode écriture, la fonction de commutation conditionnelle de la bascule haute tension puisqu'il permet de porter la ligne de bits BLi à la haute tension VPP uniquement lorsque la valeur binaire mémorisée dans les moyens de mémorisation I1,I2 est 1, c'est à dire lorsque la donnée binaire à écrire est 0.

Le drain du transistor SW est relié à une sortie S de la bascule, de manière que l'entrée L et donc la ligne de bits BLi soient reliées à cette sortie S lorsque ce transistor est conducteur.

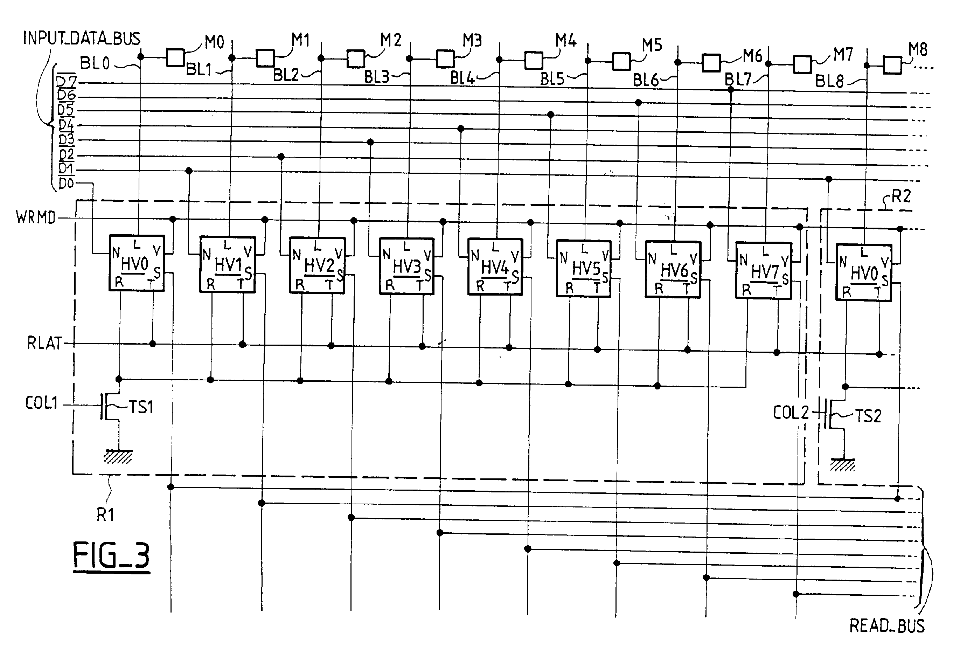

A la figure 3, on a représenté un registre de colonnes selon l'art antérieur. Ce registre R1 est associé à un mot mémoire formé de cellules mémoire M0 à M7, ainsi éventuellement qu'à d'autres mots mémoire, non représentés, adjacents verticalement à ce dernier. Les cellules mémoire M0 à M7 sont reliées à des lignes de bits respectivement BL0 à BL7. Le mot mémoire comprenant huit cellules mémoire, le registre R1 comprend huit bascules de mémorisation et de commutation HV0 à HV7. Ces bascules sont du type décrit en regard de la figure 2. Elles sont reliées par leur entrée L aux lignes de bits respectivement BL0 à BL7. Elles sont reliées par leur entrée N au bus d'entrée de données INPUT_DATA_BUS pour recevoir, lors d'une opération d'écriture, des signaux de données respectivement D0 barre à D7 barre qui portent les données inverses des données à écrire dans le mot mémoire. Elles sont reliées par leur sortie S au bus de lecture READ_BUS pour délivrer, lors d'une opération de lecture, les données lues dans les cellules mémoire respectivement M0 à M7. Elles reçoivent sur leur entrée V un même signal WRMD. Elles reçoivent sur leur entrée T un même signal RLAT.

Le registre R1 comprend enfin un transistor de sélection TS1 relié par son drain à l'entrée R de chaque bascule HV0 à HV7 et par sa source à la masse. Ce transistor de sélection TS1 reçoit sur sa grille de commande un signal COL1 de sélection de registre de colonnes qui est généré par le circuit COLDEC (figure 1).

A la figure, on a aussi partiellement représenté un autre registre R2 associé à un mot mémoire adjacent horizontalement au mot mémoire M0-M7, dont seule la première cellule M8 est visible. Ce registre R2 est connecté de la même manière que le registre R1 au bus d'entrée de données INPUT_DATA_BUS et au bus de lecture READ_BUS. Ses bascules de mémorisation et de commutation, dont seule la bascule HV0 est visible à la figure, reçoivent également les signaux WRMD et RLAT sur leur entrée respectivement V et T. En outre il comprend un transistor de sélection TS2 connecté par son drain à la sortie R de ses bascules de mémorisation et de commutation et par sa source à la masse, et qui reçoit un second signal de sélection COL2 sur sa grille de commande.

Le fonctionnement des registres est le suivant.

Lors d'une opération d'écriture dans le mot mémoire M0-M7, le signal COL1 passe à 1 pour relier les entrées R des bascules HV0 à HV7 du registre R1 à la masse. On parle de sélection du registre R1. Ensuite, les données inverses des données à écrire sont chargées dans les moyens de mémorisation haute tension des bascules HV0 à HV7 du registre R1 via les signaux RLAT dans un premier temps, et les signaux de données D0 barre à D7 barre dans un deuxième temps. Puis le signal WRMD passe à 1 pour relier les lignes de bits respectivement BL0 à BL7 à la haute tension de programmation VPP, en fonction de l'état conducteur ou bloqué du transistor SW des bascules respectivement HV0 à HV7.

Lors d'une opération de lecture dans le mot mémoire M0-M7, le signal COL1 passe à 1 pour sélectionner le registre R1. Le signal WRMD reste à zéro afin d'isoler les lignes de bits BL0 à BL7 de la haute tension VPP. Lorsque par ailleurs des signaux de commande appropriés sont appliqués sur les cellules mémoire M0 à M7, un courant circule ou non sur lignes de bits BL0 à BL7, c'est-à-dire également, sur les huit lignes du bus de lecture READ BUS reliées à la sortie S des bascules respectivement HV0 à HV7, en fonction de l'état programmé ou effacé des cellules mémoire respectivement M0 à M7. Le circuit de lecture SENSE_AMP, qui comprend huit amplificateurs de lecture respectifs, délivre alors les données lues sur le bus de sortie de données OUTPUT DATA BUS.

Comme on l'aura compris, des opérations d'écriture ou de lecture dans le mot mémoire comprenant la cellule M8 se déroule de la même façon, hormis le fait que c'est alors le signal COL2 au lieu du signal COL1 qui passe à 1 pour sélectionner le registre R2 au lieu du registre R1.

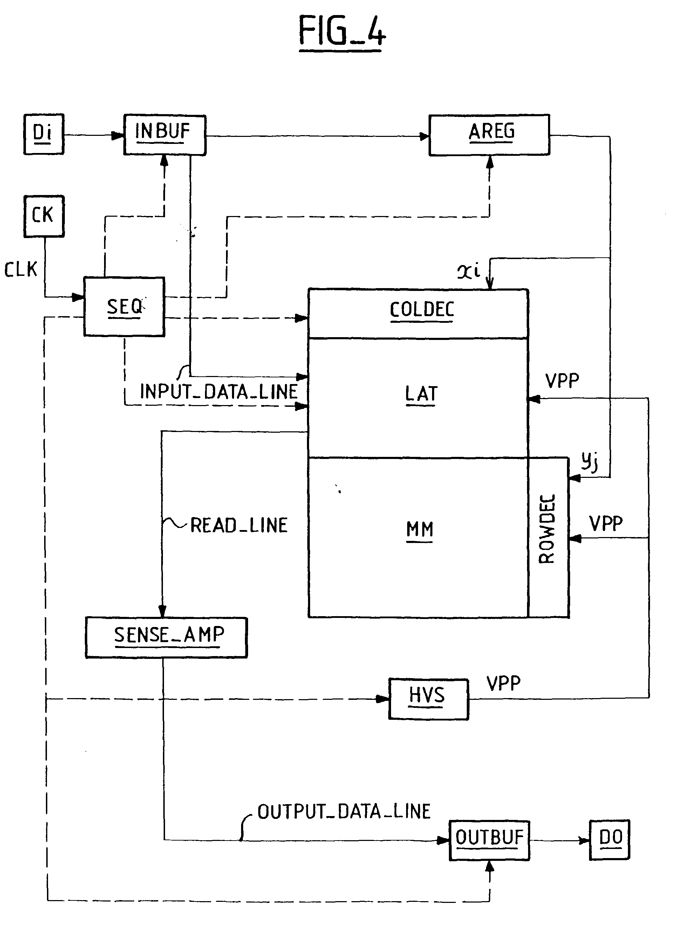

A la figure 4, on a représenté le schéma d'une mémoire selon l'invention. Sur cette figure, les mêmes éléments qu'à la figure 1 portent les même références. On se contentera ici de décrire les différences.

Les données reçues en série par l'intermédiaire de la borne d'entrée DI ne sont plus transmises dans un registre à décalage mais sont directement chargées dans les bascules de mémorisation et de commutation respectives d'un des registres de colonnes de l'ensemble LAT, à savoir le registre associé au mot mémoire dans lequel elles doivent être écrites. C'est pourquoi, la mémoire selon l'invention ne comprend pas de registre à décalage d'entrée tel que le registre DREGA de la figure 1, ni de bus d'entrée de données tel que le bus INPUT_DATA_BUS de la figure 1. A la place, elle comprend des moyens dont une unique ligne d'entrée des données INPUT_DATA_LINE reliant directement l'entrée de données Di à l'ensemble LAT de registre de colonnes à travers le circuit tampon d'entrée INBUF. Dit autrement, la mémoire selon l'invention comprend des premiers moyens pour, lors d'une opération d'écriture d'un mot binaire dans un mot mémoire déterminé, charger les données binaires d'un mot binaire reçues en série sur l'entrée de données DI directement dans des bascules de mémorisation et de commutation respectives du registre de colonnes associé audit mot mémoire dans lequel ce mot binaire doit être écrit.

On rappelle que au sens de l'invention, l'adverbe directement signifie que les données ne sont pas chargées dans un registre à décalage intermédiaire.

De plus, la mémoire selon l'invention ne comprend pas de registre à décalage de sortie tel que le registre DREGB, ni de bus de sortie de données tel que le bus OUTPUT_DATA_READ. A la place elle comprend des moyens pour, lors d'une opération de lecture d'un mot binaire dans un mot mémoire, lire successivement les données binaires mémorisées dans les cellules mémoire du mot mémoire et délivrer directement, sous forme série, chaque donnée binaire lue sur la sortie de donnée DO de la mémoire par l'intermédiaire, le cas échéant, tout au plus d'un circuit tampon de sortie. Notamment, elle comprend une unique ligne OUTPUT_READ_LINE reliant l'ensemble LAT de registres de colonnes à la sortie de données DO à travers le circuit tampon de sortie OUTBUF. En conséquence, une autre différence de la mémoire selon l'invention est que le circuit de lecture SENSE_AMP de la figure 4 comporte un unique amplificateur de lecture au lieu des huit que comprend celui de la figure 1. Ceci est aussi un avantage de l'invention car ce circuit de lecture de la mémoire selon l'invention est, de ce fait, plus petit que celui d'une mémoire selon l'art antérieur.

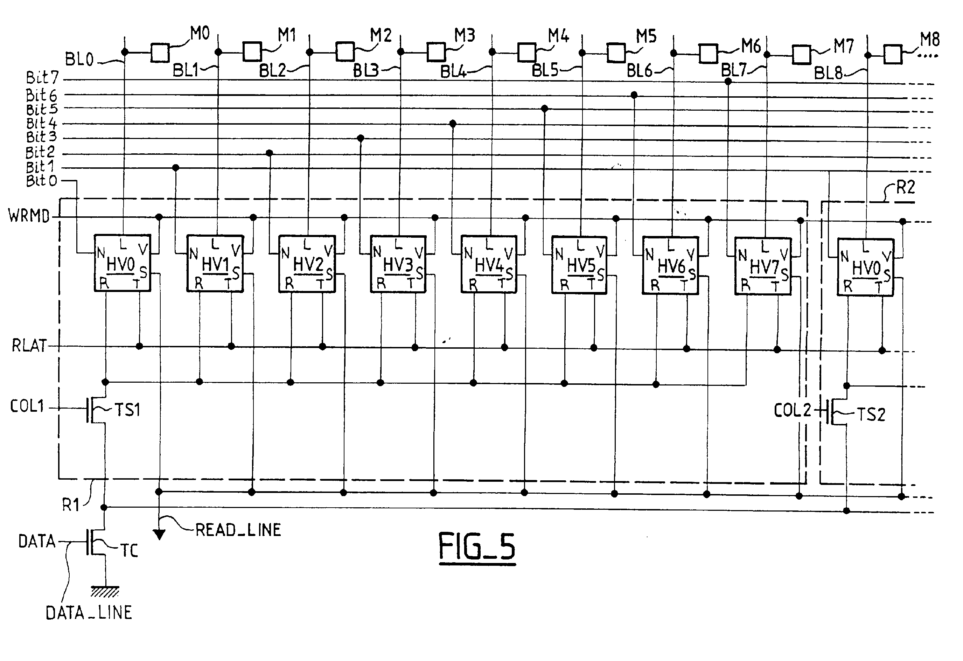

D'autres détails des premiers et seconds moyens selon l'invention apparaîtront à la lecture de la description de la figure 5 et de la figure 6.

A la figure 5, on a représenté le schéma d'un registre de colonnes selon l'invention. Sur cette figure, les mêmes éléments qu'à la figure 3 portent les même références. On se contentera ici de décrire les différences.

Structurellement, le registre de colonnes R1 est identique dans la mémoire selon l'invention et dans la mémoire selon l'art antérieur. Néanmoins, le registre R1 selon l'invention est connecté au reste de la mémoire de façon différente.

Selon une première caractéristique de l'invention, les entrées N des bascules, c'est à dire aussi les grilles de commande des transistors Ni, reçoivent des signaux de sélection de bascule respectivement Bit0 à Bit7. Un seul de ces signaux peut être à 1 à la fois, les autres étant alors nécessairement à 0. On notera que les moyens de mémorisation de chaque bascule sont remis à zéro, par un passage à 1 du signal de remise à zéro RLAT, après chaque passage à 1 d'un des signaux de sélection de bascule. De cette manière une seule bascule au plus est sélectionnée à chaque instant. Cette sélection s'opère, selon l'enseignement de l'invention, via les moyens de chargement des bascules. Un exemple de moyens pour générer les signaux de sélection Bit0 à Bit7 sera décrit plus bas en référence à la figure 6. Dit de manière plus fonctionnelle, les moyens de l'invention comprennent des moyens pour appliquer des signaux de sélection de bascule sur les moyens de chargement des bascules de mémorisation et de commutation des registres de colonnes.

Selon une seconde caractéristique de l'invention, la source du transistor de sélection TS1 des registres de colonnes tels que le registre R1 n'est pas directement connectée à la masse. Au contraire, elle est connectée à la masse à travers un transistor de chargement TC. Celui-ci ne fait pas partie d'un registre de colonnes en particulier mais est commun à tous les registres R1, R2, etc..., de la mémoire. Sa grille de commande est reliée à la ligne d'entrée de données INPUT_DATA_LINE de la mémoire pour recevoir un signal de données DATA barre qui, en mode écriture, porte la donnée inverse de la donnée à programmer. Ainsi, la donnée binaire 0 est chargée dans les moyens de mémorisation d'une bascule déterminée HV0 à HV7 du registre de colonnes lorsque : premièrement le signal de sélection Bit0 à Bit7 sur l'entrée N de ladite bascule est à 1, deuxièmement lorsque le signal DATA barre est à 1 c'est à dire lorsque la donnée binaire à écrire est un 0, et troisièmement le signal COL1 de sélection du registre de colonnes est à 1, ces trois conditions étant cumulatives. En fait, le signal DATA barre et le transistor de chargement TC coopèrent avec les moyens de sélection de registre formés des transistors de sélection TS1, TS2, ... des registres de colonnes respectivement R1, R2, .... Ils coopèrent pour le chargement d'une donnée dans celle des bascules du registre de colonnes sélectionné par les signaux de sélection de registre COL1, COL2, ... qui est sélectionnée par les signaux de sélection de bascule Bit0 à Bit7. Dit de manière plus fonctionnelle, les moyens de l'invention comprennent des moyens pour charger une donnée dans les moyens de mémorisation de la bascule sélectionnée, qui agissent via les moyens de sélection de registre formés des transistors de sélection de registres. On notera que ces moyens selon l'invention sont communs à toutes les bascules d'un registre de colonnes ainsi, le cas échéant, qu'à tous les registres de colonnes de la mémoire. C'est ce qui permet de n'avoir qu'une unique ligne d'entrée de données INPUT_DATA_LINE pour acheminer en série huit données vers les huit bascules d'un même registre de colonne, successivement sélectionnées par les signaux Bit0 à Bit7.

Selon une autre caractéristique de l'invention, les sorties S de chaque bascule du registre de colonne sont reliées à une et une seule ligne de lecture, à savoir la ligne de lecture READ_LINE présentée à la figure 4.

Pour une opération de lecture dans un mot mémoire déterminé, le fonctionnement de la mémoire selon l'invention est le suivant. Tout d'abord, le signal WRMD passe à 0, de manière à isoler les lignes de bits de la source de haute tension VPP. De plus, la ligne DATA_LINE est forcée à 1 par des moyens appropriés, en sorte que le signal DATA barre est à 1 pour permettre de relier à la masse la source du transistor de sélection de chaque registre. Ensuite, le registre de colonnes associé au mot mémoire dans lequel on veut lire un mot binaire, par exemple R1, est sélectionné par le fait que le signal COL1 de sélection de registre passe à 1. Enfin, les signaux de sélection de bascule Bit0 à Bit7 sélectionnent successivement chacune des bascules HV0 à HV7, en passant successivement à 1 pour charger la valeur binaire 1 dans les moyens de mémorisation de chaque bascule successivement. On notera que les moyens de mémorisation de chaque bascule sont remis à zéro par un passage à 1 du signal de remise à zéro RLAT après chaque passage à 1 d'un des signaux de sélection de bascule. De cette manière une seule bascule au plus est sélectionnée à chaque instant. Ainsi, à chaque fois qu'une bascule du registre sélectionné est sélectionnée, la valeur logique de la donnée mémorisée dans la cellule mémoire associée est décelable par détection de courant sur la ligne de lecture READ_LINE. Cette détection est effectuée comme on l'a dit plus haut grâce à un et un seul amplificateur de lecture du circuit de lecture SENSE_AMP de la figure 4.

A la figure 6, on a représenté un mode de réalisation de moyens pour générer les signaux de sélection de bascules Bit0 à Bit7 précités.

Ces moyens comprennent un compteur sur 3 bits référencé COMPT. Un tel compteur peut compter de zéro à sept en valeurs binaires. Ces valeurs binaires sont délivrées sur trois sorties E, F et G du compteur COMPT. Chacune d'elle est reliée directement à une ligne L1, L3 et L5 respectivement, et par l'intermédiaire d'un inverseur respectivement IE, IF et IG à une ligne L2, L4 et L6 respectivement. Huit portes logiques de type ET à trois entrées, représentées globalement sous la référence 7, sont reliées chacune à trois des lignes L1 à L6, de manière connue en soi, en sorte que la sortie de chacune de ces huit portes logiques génère une et une seule des huit combinaisons logiques des trois sorties E, F et G du compteur COMPT, et qu'un 1 logique circule sur les sorties des portes logiques 7 lorsque le compteur compte de zéro à sept. Comme on l'aura compris, les signaux Bit0 à Bit7 sont délivrés par les sorties des portes logiques 7.

Selon un avantage de l'invention, la mémoire ne comprend pas de registre à décalage d'entrée, ni le cas échéant de registre à décalage de sortie.

Selon un autre avantage, le bus d'entrée de donnée des mémoires selon l'art antérieur est remplacé par une unique ligne d'entrée de données, qui occupe moins de place.

Selon un autre avantage encore, la mémoire selon l'invention permet l'implantation aisée d'un mode d'adressage direct dans la mémoire (mode DMA pour " Direct Memory Access " en anglais).

## Revendications

1. Mémoire en circuit intégré, du type à accès série, notamment en technologie EEPROM, comportant une entrée de données (DI) et une sortie de données (DO), un plan mémoire proprement dit (MM) organisé en mots mémoire, ainsi qu'un ensemble (LAT) de registres de colonnes, un tel registre étant associé à au moins un mot mémoire de la mémoire,
caractérisée en ce qu'elle comprend des premiers moyens pour, lors d'une opération d'écriture d'un mot binaire dans un mot mémoire déterminé (M0-M7), charger les données binaires dudit mot binaire reçues en série sur l'entrée de données (DI) directement dans des bascules de mémorisation et de commutation (HV0-HV7) respectives du registre de colonnes (R1) associé audit mot mémoire (M0-M7)
et/ou des seconds moyens pour, lors d'une opération de lecture d'un mot binaire dans un mot mémoire, lire successivement les données binaires mémorisées dans les cellules mémoire du mot mémoire et délivrer directement, sous forme série, chaque donnée binaire lue sur la sortie de donnée (DO) de la mémoire.

2. Mémoire selon la revendication 1, caractérisée en ce que les bascules de mémorisation et de commutation (HV0-HV7) comprennent chacune (BHT) des moyens de mémorisation haute tension (I1-I2) pour la mémorisation d'une donnée binaire sous la forme d'une haute tension de programmation (VPP) ou d'une tension nulle, couplés à des moyens (SW,WRT) de commutation conditionnelle, pour porter à une haute tension de programmation (VPP) une ligne de bits déterminée lors d'une opération d'écriture, ainsi que des moyens de chargement (N1,N2) pour le chargement d'une donnée binaire dans les moyens de mémorisation haute tension (I1,I2).

3. Mémoire selon la revendication 2, caractérisée en ce que lesdits premiers et lesdits seconds moyens comprennent des moyens pour appliquer des signaux de sélection de bascule (BitO-Bit7) sur les moyens de chargement (N1) des bascules de mémorisation et de commutation (HV0-HV7) de chaque registre de colonnes, ainsi que des moyens pour charger des données dans les bascules, qui agissent via des moyens de sélection de registre (TS1,TS2,...) en sorte qu'ils sont communs à toutes les bascules d'un registre de colonnes déterminé.

4. Mémoire selon la revendication 3, caractérisée en ce que les moyens pour charger des données dans les bascules sont communs à tous les registres de colonnes de la mémoire.

5. Mémoire selon la revendication 1, caractérisée en ce que les seconds moyens comprennent une unique ligne de lecture (READ_BUS) reliant l'ensemble de registres de colonnes (LAT) à un circuit de lecture (SENSE_AMP).

6. Mémoire selon la revendication 5, caractérisée en ce que le circuit de lecture (SENSE_AMP) comprend un et un seul amplificateur de lecture, pour détecter un courant circulant sur la ligne de lecture (READ-LINE).

7. Mémoire selon la revendication 5 ou selon la revendication 6, caractérisée en ce qu'elle comprend une et une seule ligne d'entrée de données (OUTPUT_DATA_LINE) reliant la sortie du circuit de lecture (SENSE_AMP) à la sortie de données (DO) de la mémoire directement à travers un circuit tampon de sortie (OUTBUF).

8. Mémoire selon la revendication 1, caractérisé en ce que les premiers moyens comprennent une et une seule ligne d'entrée de données (INPUT_DATA_LINE) reliant l'entrée de données (DI) à l'ensemble (LAT) de registres de colonnes directement à travers un circuit tampon d'entrée (INBUF).
